# EUROPEAN PATENT SPECIFICATION

(11) **EP 2 448 386 B1**
(45) Date of publication and mention of the grant of the patent: **09.09.2015**
(21) Application number: 11186469.0
(22) Date of filing: 25.10.2011
(51) Int. Cl.: H05K 5/02, H01R 13/58

(54) **Power-supply cord arrangement structure**
Stromkabelanordnungsstruktur
Structure d'agencement d'alimentation électrique

(30) Priority: 26.10.2010 JP 2010239676
(43) Date of publication of application: 02.05.2012
(73) Proprietor: Makita Corporation, Anjo, Aichi 446-8502 (JP)
(72) Inventor: Sakai, Mamoru, Anjo, Aichi 446-8502 (JP); Ogura, Hironori, Anjo, Aichi 446-8502 (JP); Oshima, Kazuma, Anjo, Aichi 446-8502 (JP)
(74) Representative: Kramer Barske Schmidtchen Patentanwälte PartG mbB

(56) References cited:
- DE-C- 837 425
- DE-U1- 9 215 169
- DE-U1-202007 003 572
- FR-A1- 2 753 578

## Description

The present invention relates to a power-supply cord arrangement structure of an electrical equipment, e.g., a battery charger.

DE 92 15 169 U1 discloses a power-supply cord arrangement structure for a plug connector.

Conventionally, an electrical equipment such as a battery charger is powered by an external power source such as a household power source. Such an electrical equipment has a power-supply cord that is capable of being connected to the external power source. Generally, one (proximal) end portion of the power-supply cord is positioned within a housing of the electrical equipment and is electrically connected to an electrical device of the electrical equipment. Conversely, the other (distal) end portion of the power-supply cord is positioned outside the housing and is provided with a plug, so as to be connected to a socket (e.g., a wall socket). Further, a substantial portion of the power-supply cord including the other end portion thereof is drawn out of the housing through a cord drawing hole that is formed in the housing. Such an electrical equipment is taught, for example, by Japanese Laid-Open Utility Model Publication Number 3-41504. In the electrical equipment, the cord drawing hole is formed as a simple hole that is formed in a side wall of the housing.

Generally, the power-supply cord can be pulled in various directions other than an axial direction of the cord drawing hole, e.g., when the plug of the power-supply cord is connected to the socket or when the power-supply cord is wound around the housing for storing the electrical equipment. When the power-supply cord is pulled in such directions, the power-supply cord can be bent or flexed about a periphery of the cord drawing hole in various directions. At this time, a tensile load of the power-supply cord can be applied to the periphery of the cord drawing hole. Therefore, the power-supply cord can be applied with a reaction force corresponding to the tensile load via the periphery of the cord drawing hole due to a principle of action and reaction.

Thus, according to the electrical equipment thus constructed, the power-supply cord can be repeatedly bent or flexed in various directions about the periphery of the cord drawing hole. In addition, the power-supply cord can be repeatedly bent or flexed at the same position. Therefore, the power-supply cord can be applied with the reaction force of the tensile load at the same position. That is, the power-supply cord may have a single action point to which the reaction force can be concentrated. As a result, the power-supply cord can be rapidly deteriorated or damaged at the action point of the reaction force (the tensile load).

Thus, there is a need in the art for an improved power-supply cord arrangement structure of an electrical equipment. It is, accordingly, one object to provide an improved power-supply cord arrangement structure of an electrical equipment.

In one aspect, a power-supply cord arrangement structure provided to an electrical equipment may includes a cord drawing hole that is formed in a housing of the electrical equipment and is configured to drawing a power-supply cord therethrough, and load support portions that are formed in the housing as a portion of the cord drawing hole and are configured to support a tensile load of the power-supply cord when the power-supply cord is pulled. The load support portions are oppositely asymmetrically formed in cord pulling directions.

When the power-supply cord is pulled and flexed, the tensile load can be applied to the power-supply cord due to a principle of action and reaction. However, according to this aspect, the power-supply cord may have a plurality of different action points of a reaction force corresponding to the tensile load applied to the power-supply cord. Therefore, the reaction force applied to the power-supply cord can be effectively distributed to the different action points on the power-supply cord. That is, the reaction force can be prevented from being concentrated in a single action point. As a result, the power-supply cord can be avoided from being rapidly deteriorated or damaged. This means that the power-supply cord can have a long service life.

Further, the load support portions include outer support portions that are oppositely asymmetrically formed in the cord pulling directions.

Further, the load support portions may include inner support portions that are oppositely asymmetrically formed in the cord pulling directions.

Optionally, the power-supply cord arrangement structure may include a cord retainer portion having a cord guide wall member that is formed in the housing. The cord guide wall member defines a winding guide path so as to windingly guide and support the power-supply cord along the guide path while the power-supply cord is bent a plurality of times.

According to this aspect, the power-supply cord can be effectively prevented from moving laterally. As a result, the power-supply cord can be effectively prevented from being pulled out from the housing when it is pulled laterally.

Other objects, features and advantages will be readily understood after reading the following detailed description together with the accompanying drawings and the claims.

FIG. 1(A) is a perspective view of a battery charger having a power-supply cord arrangement structure according to a first representative embodiment;
FIG. 1(B) is an enlarged view of an encircled portion of FIG. 1(A);
FIG. 2 is a perspective view of a bottom cover to which a power-supply cord (a portion of which is shown) is attached;
FIG. 3 is a plan view of FIG. 2;
FIG. 4 is a partially enlarged view of FIG. 2, which view illustrates a condition in which the power-supply cord is removed;
FIG. 5 is a plan view of FIG. 4, which view illustrates a condition in which the power-supply cord is attached;
FIG. 6(A) is a partially cross-sectional view of FIG. 5, which view illustrates a condition in which the power-supply cord is not pulled or flexed;
FIG. 6(B) is a view similar to FIG. 6(A), which view illustrates a condition in which the power-supply cord is pulled or flexed forwardly;
FIG. 6(C) is a view similar to FIG. 6(A), which view illustrates a condition in which the power-supply cord is pulled or flexed backwardly;
FIG. 6(D) is a partially cross-sectional view of the power-supply cord, which views illustrates that the power-supply cord has a plurality of action points to which a reaction force (a tensile load) can be applied;
FIG. 7(A) is a view corresponding to FIG. 6(A), which view illustrates a power-supply cord arrangement structure according to a second representative embodiment;
FIG. 7(B) is a view corresponding to FIG. 6(B);
FIG. 7(C) is a view corresponding to FIG. 6(C);
FIG. 7(D) is a view corresponding to FIG. 6(D);
FIG. 8(A) is a view corresponding to FIG. 6(A), which view illustrates a power-supply cord arrangement structure according to a third representative embodiment;
FIG. 8(B) is a view corresponding to FIG. 6(B);
FIG. 8(C) is a view corresponding to FIG. 6(C);
FIG. 8(D) is a view corresponding to FIG. 6(D);
FIG. 9(A) is a view corresponding to FIG. 6(A), which view illustrates a power-supply cord arrangement structure according to a fourth representative embodiment;
FIG. 9(B) is a view corresponding to FIG. 6(B);
FIG. 9(C) is a view corresponding to FIG. 6(C);
FIG. 9(D) is a view corresponding to FIG. 6(D);
FIG. 10(A) is a view corresponding to FIG. 6(A), which view illustrates a conventional power-supply cord arrangement structure;
FIG. 10(B) is a view corresponding to FIG. 6(B);
FIG. 10(C) is a view corresponding to FIG. 6(C); and
FIG. 10(D) is a view corresponding to FIG. 6(D).

Next, the representative embodiments will be described with reference to the drawings.

### First Detailed Representative Embodiment

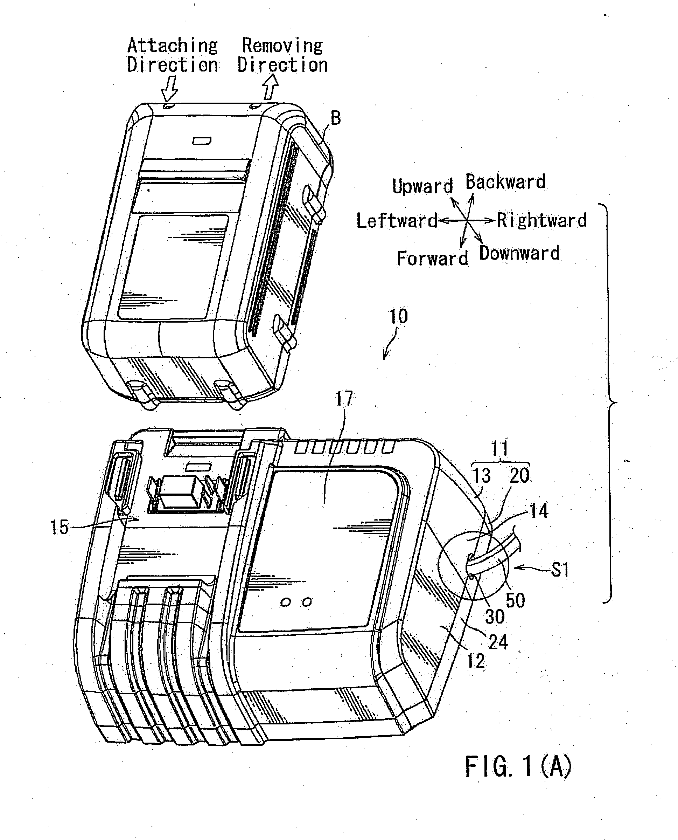

A first detailed representative embodiment will be described with reference to FIGS. 1(A) to 6(D).

In this embodiment, a battery charger 10 is exemplified as an electrical equipment. The battery charger 10 is constructed to receive a battery pack B thereon in order to charge the same. In particular, the battery charger 10 is constructed such that the battery pack B can be attached to an upper portion thereof while being slid forwardly therealong from a back side of the battery charger 10. Further, in the description, as shown in FIG. 1(A), forward and backward, rightward and leftward, and upward and downward respectively correspond to forward and backward, rightward and leftward, and upward and downward of the battery charger 10.

Further, the battery charger 10 is a device that is specially designed in order to charge the battery pack B. Conversely, the battery pack B is designed to be used as a power source of an electrical power tool (not shown) such as an electrical drill and contains a rechargeable battery such as a lithium ion battery therein.

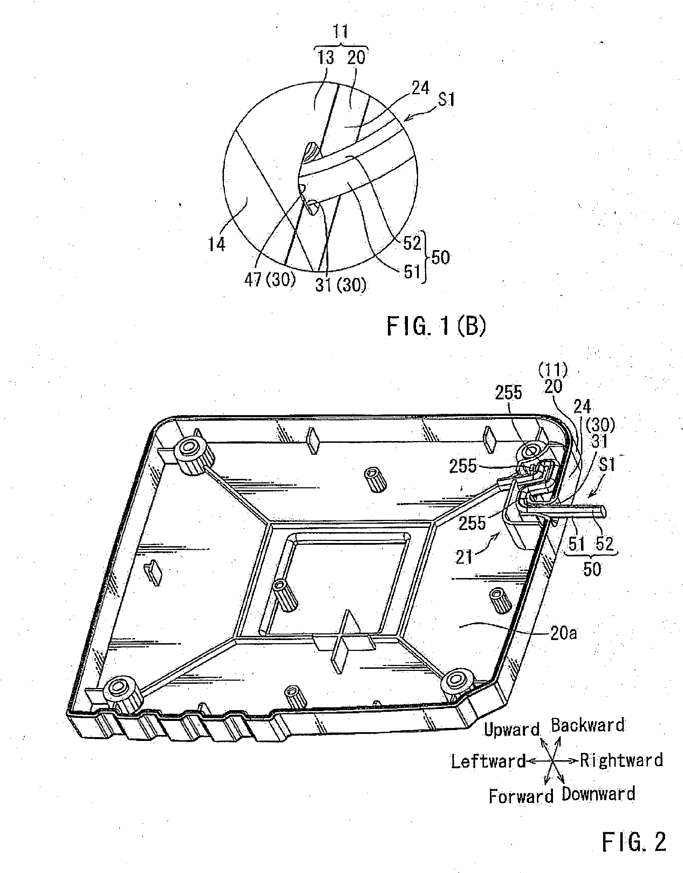

As shown in FIG. 1(A), the battery charger 10 includes a housing 11 that contains an electrical device (not shown), e.g., a unit of electrical components, for charging. The housing 11 is composed of a bottomless housing main body 13 and a bottom cover 20 and has a power-supply cord arrangement structure S1 formed therein. As will be recognized, the bottom cover 20 can be fitted to or mated with the housing main body 13 so as to close an open bottom of the housing main body 13. The housing main body 13 and the bottom cover 20 are respectively formed by molding of plastic materials such as polyphenylene ether (PPE) resin. The housing main body 13 has an annular side wall 14 and an upper wall 17. Further, the housing main body 13 has a battery attaching portion 15 that is formed in a left-side half of the upper wall 17 thereof. The battery attaching portion 15 may preferably be formed as a portion of the housing main body 13 during molding of the housing main body 13. Conversely, the bottom cover 20 has an annular side wall 24 and a bottom wall 20a (FIG. 2). Further, the side wall 24 of the bottom cover 20 is shaped to fit to or mate with the side wall 14 of the housing main body 13.

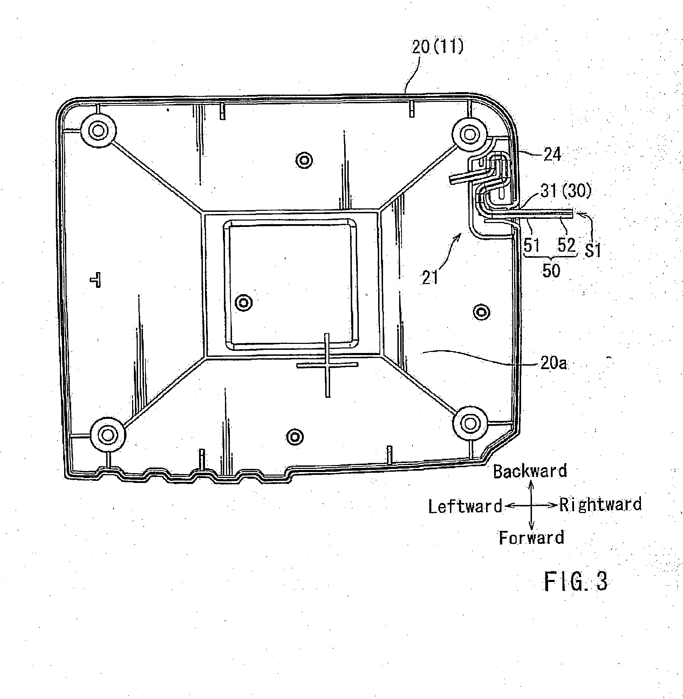

The battery charger 10 is constructed to be powered by an external power source such as a household power source. Therefore, the battery charger 10 has a power-supply cord 50 that is capable of being connected to the external power source in order to power the electrical device of the battery charger 10. As shown in FIGS. 2 and 3, one (proximal) end portion of the power-supply cord 50 is positioned within the housing 11 of the battery charger 10 and is electrically connected to the electrical device of the battery charger 10. Conversely, the other (distal) end portion of the power-supply cord 50 is positioned outside the housing 11 and is provided with a plug (not shown), so as to be connected to a socket (e.g., a wall socket). Further, a substantial portion of the power-supply cord 50 including the other end portion thereof is drawn from the housing 11 through a cord drawing hole 30 that is formed in an outer wall 12 of the housing 11.

As best shown in FIGS. 1(A) and 1(B), the cord drawing hole 30 (which will be hereinafter simply referred to as a cord hole 30) is formed in a right side portion of the outer wall 12 of the housing 11 so as to straddle or extend across the side wall 14 of the housing main body 13 and the side wall 24 of the bottom cover 20. In particular, as best shown in FIG. 1(B), the cord hole 30 is composed of a hole main portion 31 (a hole lower portion) that is formed in a (upper) periphery of the side wall 24 of the bottom cover 20 and a hole complementary portion 47 (a hole upper portion) that is formed in a (lower) periphery of the side wall 14 of the housing main body 13. The hole main portion 31 and the hole complementary portion 47 are respectively arranged and shaped to be aligned with each other when the bottom cover 20 is coupled to the housing main body 13. Thus, the cord hole 30 can be formed in the housing 11 when the bottom cover 20 is coupled to the housing main body 13.

Further, the cord hole 30 has a functional structure, as will be hereinafter described. However, such a functional structure is substantially localized to the hole main portion 31 formed in the bottom cover 20. Such a functional structure substantially constitutes a portion of the power-supply cord arrangement structure S1.

As best shown in FIG. 1(B), the power-supply cord 50 is a two-core flat cable that has a substantially rectangular shape in cross section. The power-supply cord 50 has opposite wide surfaces 51 and opposite narrow surfaces 52. That is, the power-supply cord 50 has a thickness smaller than a width thereof. Thus, the power-supply cord 50 can be easily flexed or bent in a thickness direction than in a width direction. Further, each of the narrow surfaces 52 of the power-supply cord 50 is formed as a curved surface whereas each of the wide surfaces 51 of the power-supply cord 50 is formed as a flattened surface. Therefore, the power-supply cord 50 can be further flexible in the thickness direction than in the width direction.

As best shown in FIG. 3, in this embodiment, the hole main portion 31 (the cord hole 30) is shaped to receive the power-supply cord 50 while the wide surfaces 51 of the power-supply cord 50 are directed in a front-back direction of the battery charger 10 (the housing 11). Preferably, the hole main portion 31 is shaped to have a vertically elongated shape.

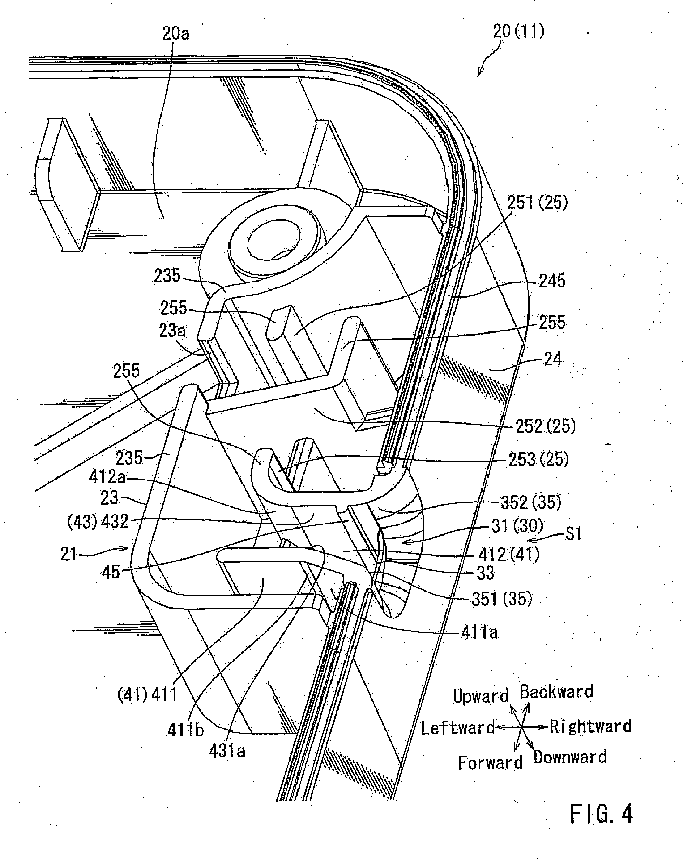

The power-supply cord arrangement structure S1 will be described in detail.
First, as best shown in FIG. 4, the hole main portion 31 has a vertically elongated opening portion 33 defined by a substantially U-shaped end peripheral portion 35 that is formed in a right side portion of the side wall 24 of the bottom cover 20. The opening portion 33 (the end peripheral portion 35) may constitute a portion (an exterior portion) of the hole main portion 31 (the cord hole 30). The end peripheral portion 35 is rounded or chamfered such that the opening portion 33 (the hole main portion 31) can be flared outwardly (rightwardly). The end peripheral portion 35 includes a front (load) support portion 351 and a back (load) support portion 352, each of which may be referred to as an outer support portion (surface). The front support portion 351 and the back support portion 352 are positioned opposite to each other in a front-back direction of the side wall 24 of the bottom cover 20 and respectively function as load support portions that are capable of supporting a tensile load of the power-supply cord 50 when the power-supply cord 50 is flexed or bent.

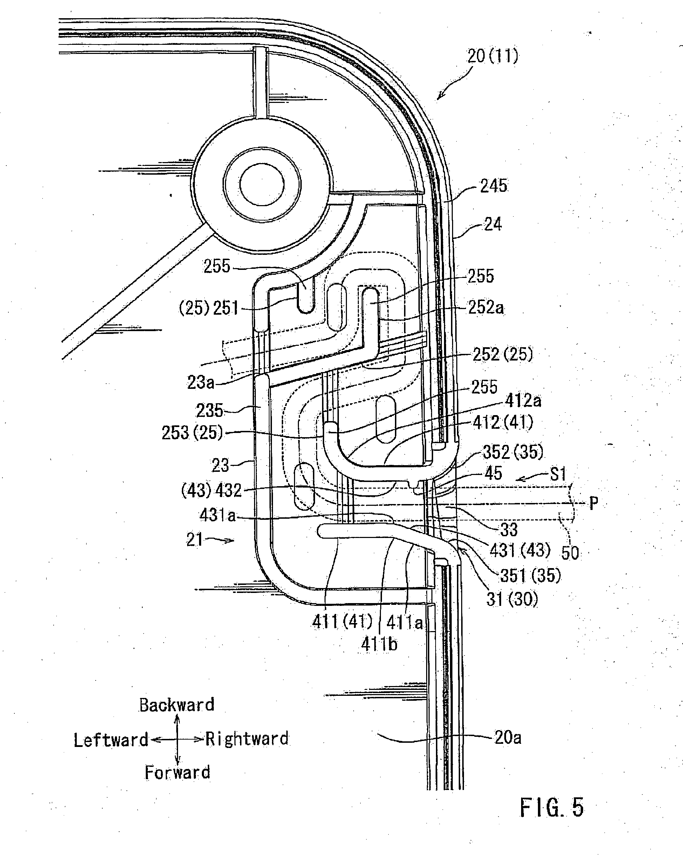

Further, as best shown in FIG. 5, the end peripheral portion 35 is asymmetrically or non-uniformly rounded or chamfered in plan such that the front support portion 351 can have a rounded shape different from the rounded shape of the back support portion 352. In particular, the end peripheral portion 35 is chamfered such that the front support portion 351 can have a radius of curvature different from the radius of curvature of the back support portion 352. Thus, the front support portion 351 and the back support portion 352 can be oppositely asymmetrically formed in the front-back direction.

The power-supply cord arrangement structure S 1 includes a guide rib member 41 that is capable of supporting or guiding the power-supply cord 50. As best shown in FIG. 5, the guide rib member 41 has an inner guide portion (surface) 43 and is vertically positioned on the inner surface of the bottom wall 20a of the bottom cover 20 while the inner guide portion 43 is aligned and continuous with the opening portion 33 of the hole main portion 31 (the cord hole 30). The guide rib member 41 (the inner guide portion 43) may constitute a portion (an interior portion) of the hole main portion 31 (the cord hole 30). In particular, as shown in FIGS. 4 and 5, the guide rib member 41 includes a plate-shaped front guide rib 411 and a plate-shaped back guide rib 412. The front guide rib 411 and the back guide rib 412 respectively have a front inner guide portion (surface) 431 (a portion of the inner guide portion 43) and a back inner guide portion (surface) 432 (a portion of the inner guide portion 43), each of which may be referred to as an inner support portion (surface). The front inner guide portion (surface) 431 and the back inner guide portion (surface) 432 are positioned opposite to each other in the front-back direction and respectively function as the load support portions that are capable of supporting the tensile load of the power-supply cord 50 when the power-supply cord 50 is flexed or bent.

Further, as best shown in FIG. 5, the guide rib member 41 is asymmetrically shaped in plan such that the front guide rib 411 and the back guide rib 412 (the front inner guide portion 431 and the back inner guide portion 432) respectively have cross-sectional shapes different from each other. In particular, the front guide rib 411 has an angled portion 411a that is forwardly bent about a bending position 411b. That is, the front guide rib 411 is shaped such that the front inner guide portion 431 can be flared outwardly (rightwardly). As a result, the front inner guide portion 431 can have a convex portion 431a corresponding to the bending position 411 b of the front guide rib 411. Conversely, the back guide rib 412 has a curved inner end portion 412a that is backwardly bent. That is, the back guide rib 412 is shaped such that the back inner guide portion (surface) 432 can be outwardly curved. In addition, the back guide rib 412 has a vertically elongated projection 45 that is formed in the back inner guide portion (surface) 432. The projection 45 is positioned adjacent to the opening portion 33 of the hole main portion 31. Thus, the front guide rib 411 and the back guide rib 412 (the front inner guide portion 431 and the back inner guide portion 432) can be oppositely asymmetrically formed.

Further, a horizontal bottom end surface of the front guide rib 411 is integrally connected to the inner surface of the bottom wall 20a of the bottom cover 20. Conversely, as shown in FIGS. 4 and 5, a vertical proximal (right) end surface of the front guide rib 411 (the angled portion 411a) is integrally connected to an inner surface of the side wall 24 of the bottom cover 20 such that the front inner guide portion 431 can be continuous with the front support portion 351 of the end peripheral portion 35. Similarly, a horizontal bottom end surface of the back guide rib 412 is integrally connected to the inner surface of the bottom wall 20a of the bottom cover 20. Conversely, as shown in FIGS. 4 and 5, a vertical proximal (right) end surface of the back guide rib 412 is integrally connected to the inner surface of the side wall 24 of the bottom cover 20 such that the back inner guide portion 432 can be continuous with the back support portion 352 of the end peripheral portion 35.

The power-supply cord arrangement structure S1 (the functional structure) further includes a cord retainer portion 21 that is capable of supporting or guiding the power-supply cord 50. The cord retainer portion 21 is integrally formed in the bottom cover 20, so as to be positioned adjacent to the hole main portion 31 (the cord hole 30). As best shown in FIG. 3, the cord retainer portion 21 is arranged and constructed to support or guide the power-supply cord 50 while the wide surfaces 51 of the power-supply cord 50 are substantially vertically positioned (i.e., while the narrow surfaces 52 of the power-supply cord 50 are substantially horizontally positioned). In addition, as shown in FIGS. 2 and 3, the cord retainer portion 21 is configured to windingly guide and support the power-supply cord 50 while the power-supply cord 50 is bent or wound a plurality of times. Thus, the power-supply cord 50 can be effectively prevented from moving laterally (rightward and leftward).

In particular, as shown in FIGS. 4 and 5, the cord retainer portion 21 is constructed of a partition wall 23 that defines a cord guide area of the cord retainer portion 21 and a cord guide wall member 25 that is capable of windingly guiding the power-supply cord 50 within the cord guide area. The partition wall 23 is vertically positioned on an inner surface of the bottom wall 20a of the bottom cover 20 while surrounding the guide rib member 41 (the hole main portion 31). A horizontal bottom end surface of the partition wall 23 is integrally connected to the inner surface of the bottom wall 20a. Conversely, opposite vertical end surfaces of the partition wall 23 are respectively integrally connected to the inner surface of the side wall 24 of the bottom cover 20. Thus, the cord guide area of the cord retainer portion 21 can be defined between the partition wall 23 and a portion of the side wall 24 of the bottom cover 20. Further, the partition wall 23 has a vertically elongated rectangular notch 23a that is formed in an upper end periphery of a substantially central portion thereof. The notch 23a is shaped to loosely receive the power-supply cord 50.

The cord guide wall member 25 is vertically positioned on the inner surface of the bottom wall 20a of the bottom cover 20 within the cord guide area of the cord retainer portion 21. In particular, the cord guide wall member 25 includes a flat plate-shaped first wall portion 251, an angled plate-shaped second wall portion 252 having an L-shape in cross section, and a flat plate-shaped third wall portion 253. As best shown in FIG. 5, the first wall portion 251 is positioned adjacent to a back portion of the partition wall 23 in the cord guide area of the cord retainer portion 21. A horizontal bottom end surface of the first wall portion 251 is integrally connected to the inner surface of the bottom wall 20a of the bottom cover 20. Conversely, a vertical proximal end surface of the first wall portion 251 is connected to the partition wall 23. The second wall portion 252 is positioned adjacent to the notch 23a formed in the partition wall 23 in the cord guide area of the cord retainer portion 21. Further, the second wall portion 252 is positioned such that an angled portion 252a thereof can be positioned parallel to the first wall portion 251. A horizontal bottom end surface of the second wall portion 252 thus positioned is integrally connected to the inner surface of the bottom wall 20a of the bottom cover 20. Conversely, a vertical proximal end surface of the second wall portion 252 is integrally connected to the partition wall 23 so as to extend along the notch 23a. The third wall portion 253 is positioned on a central portion of the cord guide area of the cord retainer portion 21. A horizontal bottom end surface of the third wall portion 253 is integrally connected to the inner surface of the bottom wall 20a of the bottom cover 20. Conversely, a vertical proximal end surface of the third wall portion 253 is integrally connected to the curved inner end portion 412a of the back guide rib 412 of the guide rib member 41.

As shown by a broken line in FIG. 5, the guide rib member 41 and the cord retainer portion 21 (the partition wall 23 and the cord guide wall member 25) thus arranged and constructed can form a winding guide path P that windingly extends from the notch 23a formed in the partition wall 23 toward the opening portion 33. Thus, the power-supply cord 50 can be disposed along the guide path P while the wide surfaces 51 thereof are substantially vertically positioned (FIGS. 2 and 3).

As shown in FIG. 5, because the guide path P is formed as a winding path, the power-supply cord 50 disposed in the cord guide area of the cord retainer portion 21 along the guide path P can windingly extend from the notch 23a toward the opening portion 33. That is, the power-supply cord 50 can be bent backwardly about 90 degrees around the first wall portion 251 and then be turned about 180 degrees around the second wall portion 252 (the angled portion 252a). Thereafter, the power-supply cord 50 can be bent leftwardly about 90 degrees along the second wall portion 252 and then be bent forwardly about 90 degrees around the third wall portion 253. Further, the power-supply cord 50 can be turned rightwardly about 90 degrees around the curved inner end portion 412a of the back guide rib 412 and then be drawn from the opening portion 33 via the guide rib member 41. Thus, the power-supply cord 50 can be windingly positioned in the cord guide area of the cord retainer portion 21 before it is drawn from the housing 11 through the hole main portion 31 (the cord drawing hole 30). Therefore, the power-supply cord 50 can be effectively prevented from moving laterally (rightward and leftward).

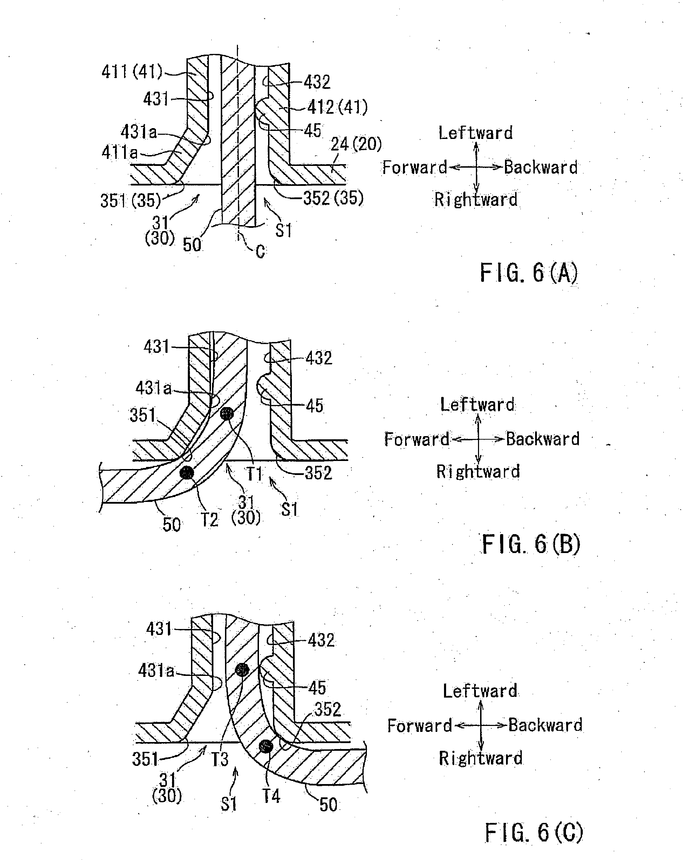

Further, the power-supply cord 50 thus disposed can be extended along a guide center line C defined by the front and back guide ribs 411 and 412 and then be drawn from the housing 11 through the hole main portion 31 (FIG. 6(A)). As will be appreciated, the guide center line C can be defined by substantial portions (portions except for the angled portion 411a and the projection 45) of the front and back guide ribs 411 and 412 (the front and back inner guide portions 431 and 432), so as to be extended perpendicular to the side wall 24 of the bottom cover 20 (the outer wall 12 of the housing 11).

Further, as shown in FIG. 2, the first to third wall portions 251, 252 and 253 (the cord guide wall member 25) are respectively shaped such that horizontal upper end surfaces 255 thereof can be positioned above upper end peripheries of the wide surfaces 51 of the power-supply cord 50 when the power-supply cord 50 is disposed along the guide path P. In other words, the first to third wall portions 251, 252 and 253 are respectively shaped to contact the whole wide surfaces 51 of the power-supply cord 50 disposed in the guide path P, so as to reliably guide and support the power-supply cord 50. Thus, the first to third wall portions 251, 252 and 253 can reliably support the power-supply cord 50 that is windingly disposed along the guide path P. Conversely, the partition wall 23 is shaped such that a horizontal upper end surface 235 thereof can be positioned above the upper end surfaces 255 of the first to third wall portions 251, 252 and 253. Similarly, the side wall 24 of the bottom cover 20 is shaped such that a horizontal upper end surface 245 thereof can be positioned above the upper end surfaces 255 of the first to third wall portions 251, 252 and 253. Preferably, the partition wall 23 and the side wall 24 of the bottom cover 20 are respectively shaped such that the horizontal upper end surface 235 and the horizontal upper end surface 245 thereof can be positioned above the upper curved narrow surface 52 of the power-supply cord 50 disposed in the guide path P.

Next, an operation of the power-supply cord arrangement structure S1 of the battery charger 10 thus constructed will now be described with reference to FIGS. 6(A) to 6(D).
As previously described, the power-supply cord 50 is disposed along the guide path P, so as to be windingly positioned in the cord guide area of the cord retainer portion 21 (FIGS. 2, 3 and 5). The power-supply cord 50 thus positioned can be effectively prevented from moving laterally (rightward and leftward). As a result, the power-supply cord 50 can be effectively prevented from being pulled out from the housing 11 when it is pulled laterally (rightwardly in this embodiment).

As shown in FIG. 6(A), when the power-supply cord 50 thus disposed is not pulled forwardly or backwardly (which may be referred to as cord pulling directions), the power-supply cord 50 can substantially extend along the guide center line C so as to not substantially contact the front and back inner guide portions 431 and 432 and the front and back support portions 351 and 352. However, as shown in FIG. 6(B), when the power-supply cord 50 is pulled forwardly, the power-supply cord 50 can be bent or flexed forwardly, so as to be pressed against the convex portion 431a of the front inner guide portion 431 and the front support portion 351. At this time, the tensile load of the power-supply cord 50 can be applied to the convex portion 431a and the front support portion 351. As a result, a reaction force corresponding to the tensile load can be applied to the power-supply cord 50 via the convex portion 431a and the front support portion 351 due to a principle of action and reaction. However, the reaction force can be distributed to a (first) action point (point of action) T1 and a (second) action point T2 on the power-supply cord 50, which action points respectively correspond to the convex portion 431a and the front support portion 351.

Conversely, as shown in FIG. 6(C), when the power-supply cord 50 is pulled backwardly, the power-supply cord 50 can be bent or flexed backwardly, so as to be pressed against the projection 45 of the back inner guide portion 432 and the back support portion 352. At this time, the tensile load of the power-supply cord 50 can be applied to the projection 45 and the back support portion 352. As a result, the reaction force corresponding to the tensile load can be applied to the power-supply cord 50 via the projection 45 and the back support portion 352. However, the reaction force can be distributed to a (third) action point T3 and a (fourth) action point T4 on the power-supply cord 50, which action points respectively correspond to the projection 45 and the back support portion 352. Further, in this embodiment, the projection 45 and the back support portion 352 are arranged and constructed such that the action point T3 and the action point T4 cannot coincide with the action point T1 and the action point T2.

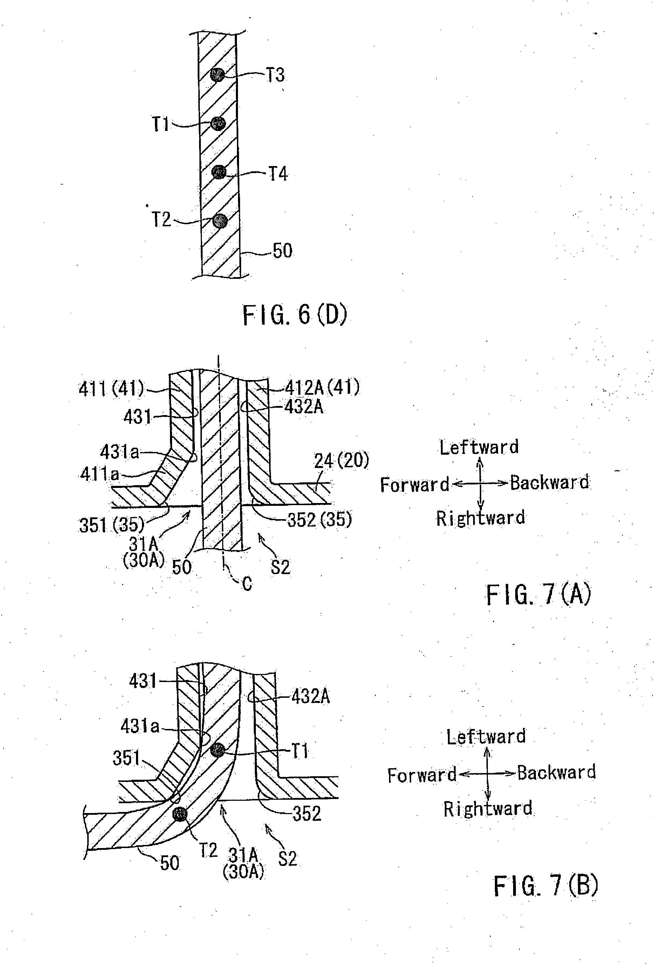

Thus, when the power-supply cord 50 is pulled forwardly and backwardly, the power-supply cord 50 can contact the load support portions at a plurality of different contact points, so that the reaction force corresponding to the tensile load applied to the power-supply cord 50 can be received by a plurality of action points (i.e., the action points T1 to T4) that are different from each other (FIG. 6(D)). That is, the reaction force can be prevented from being concentrated in a single action point.

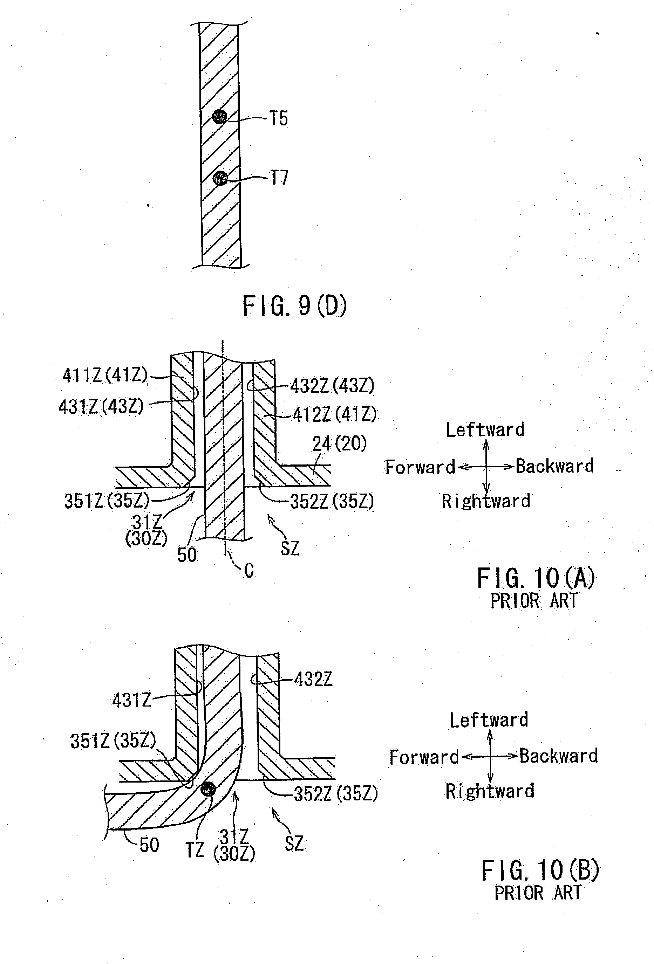

To the contrary, as shown in FIG. 10(A) to 10(D), a conventional power-supply cord arrangement structure SZ includes a hole main portion 31Z (a cord hole 30Z) corresponding to the hole main portion 31 (the cord hole 30) of the present embodiment. The hole main portion 31Z has an end peripheral portion 35Z that is formed in the side wall 24 of the bottom cover 20. Unlike the present embodiment, the end peripheral portion 35Z is symmetrically or uniformly chamfered such that a front support portion 351Z can have the same rounded shape as the back support portion 352Z. Further, the power-supply cord arrangement structure SZ includes a guide rib member 41Z (corresponding to the guide rib member 41 of the present embodiment) having an inner guide portion 43Z (corresponding to the inner guide portion 43 of the present embodiment). The guide rib member 41Z includes a front guide rib 411Z and a back guide rib 412Z. The front guide rib 411Z and the back guide rib 412Z respectively have a front inner guide portion 431Z and a back inner guide portion 432Z. However unlike the present embodiment, the guide rib member 41Z is symmetrically shaped in cross section such that the front guide rib 411Z and the back guide rib 412Z (the front inner guide portion 431Z and the back inner guide portion 432Z) respectively have the same cross-sectional shapes as each other.

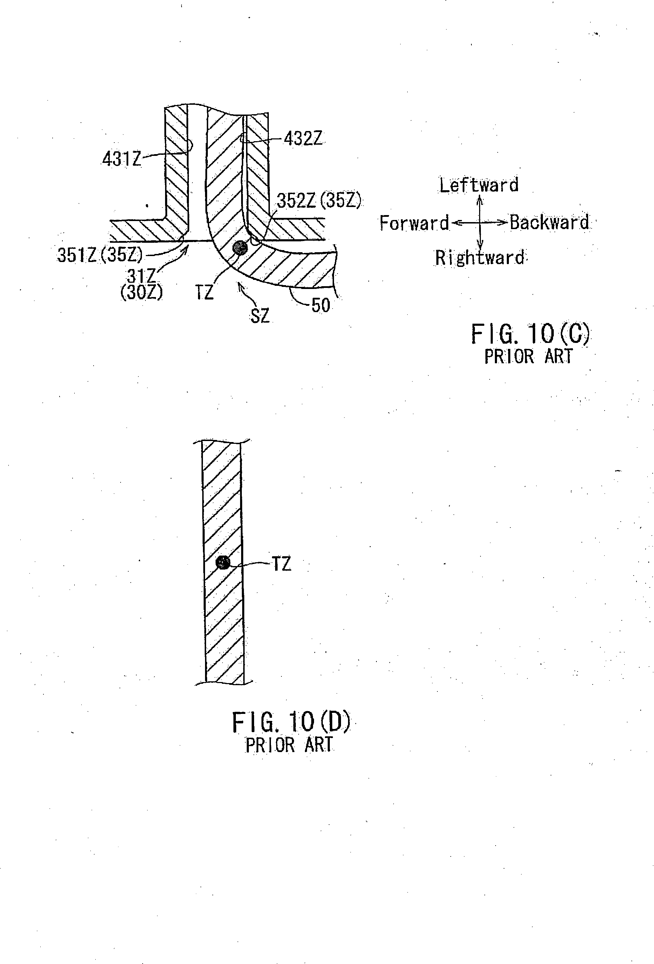

As shown in FIG. 10(A), similar to the present embodiment, when the power-supply cord 50 is not pulled forwardly or backwardly, the power-supply cord 50 can substantially extend along the guide center line C so as to not substantially contact the front and back inner guide portions 431Z and 432Z and the front and back support portions 351Z and 352Z (the load support portions). However, as shown in FIG. 10(B), when the power-supply cord 50 is pulled forwardly, the power-supply cord 50 can be bent or flexed forwardly, so as to be pressed against the front support portion 351Z. At this time, the tensile load of the power-supply cord 50 can be applied to the front support portion 351Z. As a result, the reaction force corresponding to the tensile load can be applied to the power-supply cord 50 via the front support portion 351Z. The reaction force can be concentrated a single action point TZ which corresponds to the front support portion 351Z. Similarly, as shown in FIG. 10(C), when the power-supply cord 50 is pulled backwardly, the power-supply cord 50 can be bent or flexed backwardly, so as to be pressed against the back support portion 352Z. At this time, the tensile load of the power-supply cord 50 can be applied to the back support portion 352Z. As a result, the reaction force corresponding to the tensile load can be applied to the power-supply cord 50 via the back support portion 352Z. The reaction force can be concentrated to the action point TZ on the power-supply cord 50, which point corresponds to the back support portion 352Z.

Thus, in the conventional power-supply cord arrangement structure SZ, when the power-supply cord 50 is pulled forwardly and backwardly, the power-supply cord 50 can contact the load support portions at the same single contact point, so that the reaction force corresponding to the tensile load applied to the power-supply cord 50 can be received by the same action point TZ (FIG. 10(D)). That is, the reaction force can be prevented from being concentrated in a single action point. As a result, the power-supply cord 50 can be rapidly deteriorated or damaged at the action point TZ.

According to the power-supply cord arrangement structure S1, unlike the conventional power-supply cord arrangement structure SZ, the power-supply cord 50 may have four different action points T 1 to T4 of the reaction force. Therefore, the reaction force can be prevented from being concentrated in a single action point. As a result, the power-supply cord 50 can be avoided from being rapidly deteriorated or damaged. This means that the power-supply cord 50 can have a long service life.

In addition, in this embodiment, because the power-supply cord 50 can be windingly positioned in the cord guide area of the cord retainer portion 21, the power-supply cord 50 can be effectively restricted from being pulled out from the housing 11 even when it is pulled laterally. Therefore, it is not necessary to secure the power-supply cord 50 to the housing 11 using an additional member (e.g., a cord clamp member) in order to prevent the power-supply cord 50 from being pulled out from the housing 11. As a result, it is possible to reduce the number of component parts of the battery charger 10.

Further, in this embodiment, each of the horizontal upper end surfaces 255 of the cord guide wall member 25 is shaped to be positioned above the upper end peripheries of the wide surfaces 51 of the power-supply cord 50 when the power-supply cord 50 is disposed in the cord guide area of the cord retainer portion 21 along the guide path P. Therefore, the power-supply cord 50 can be reliably supported by the cord guide wall member 25 along the guide path P. In addition, the power-supply cord 50 can be effectively prevented from being pinched between the housing main body 13 and the bottom cover 20 when the housing main body 13 and the bottom cover 20 are coupled to each other while the power-supply cord 50 is disposed in the cord guide area of the cord retainer portion 21 along the guide path P. Therefore, it is easily and quickly manufacture the battery charger 10.

### Second Detailed Representative Embodiment

The second detailed representative embodiment will now be described in detail with reference to FIGS. 7(A) to 7(D).

Because the second embodiment relates to the first embodiment, only the constructions and elements that are different from the first embodiment will be explained in detail. Elements that are the same in the first and second embodiments will be identified by the same reference numerals and a detailed description of such elements may be omitted.

As shown in FIG. 7(A), in this embodiment, the hole main portion 31 (the cord hole 30) of the first embodiment is replaced with a hole main portion 31A (the cord hole 30A). Further, the power-supply cord arrangement structure S1 of the first embodiment is replaced with a power-supply cord arrangement structure S2. Similar to the first embodiment, the guide rib member 41 of the power-supply cord arrangement structure S2 may constitute a portion of the hole main portion 31A (the cord hole 30A). Further, the guide rib member 41 includes a back guide rib 412A corresponding to the back guide rib 412 of the first embodiment. The back guide rib 412A has a back inner guide portion 432A. However, in this embodiment, the projection 45 in the first embodiment is omitted. That is, no vertically elongated projection is formed in the back inner guide portion 432A.

In this embodiment, as shown in FIG. 7(B), when the power-supply cord 50 is pulled forwardly, similar to the first embodiment, the tensile load of the power-supply cord 50 can be applied to the convex portion 431a and the front support portion 351. As a result, the reaction force corresponding to the tensile load can be applied to the power-supply cord 50 via the convex portion 431a and the front support portion 351. The reaction force can be distributed to the action point T1 and the action point T2 on the power-supply cord 50.

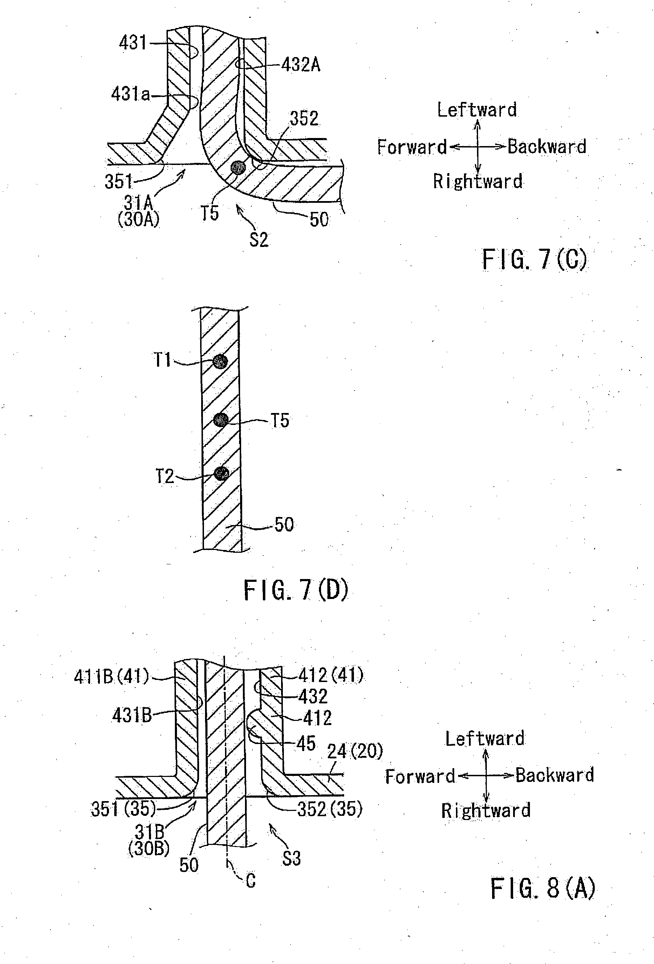

Conversely, as shown in FIG. 7(C), when the power-supply cord 50 is pulled backwardly, unlike the first embodiment, the power-supply cord 50 can be bent or flexed backwardly, so as to be pressed against the back support portion 352. At this time, the tensile load of the power-supply cord 50 can be applied to the back support portion 352. As a result, the reaction force corresponding to the tensile load can be applied to the power-supply cord 50 via the back support portion 352. The reaction force can be applied to a (fifth) action point T5 on the power-supply cord 50, which point corresponds to the back support portion 352. Further, in this embodiment, the back support portion 352 is arranged and constructed such that the action point T5 cannot coincide with the action point T1 and the action point T2.

Thus, in this embodiment, when the power-supply cord 50 is pulled forwardly and backwardly, the power-supply cord 50 can contact the load support portions at a plurality of different contact points, so that the reaction force corresponding to the tensile load applied to the power-supply cord 50 can be received by a plurality of action points (i.e., the three action points T1, T2 and T5) that are different from each other (FIG. 7(D)). That is, the reaction force can be prevented from being concentrated in a single action point.

According to the power-supply cord arrangement structure S2, the power-supply cord 50 may have three different action points T1, T2 and T5 of the reaction force. Therefore, similar to the power-supply cord arrangement structure S1 of the first embodiment, the reaction force can be prevented from being concentrated in a single action point. As a result, the power-supply cord 50 can be avoided from being rapidly deteriorated or damaged. This means that the power-supply cord 50 can have a long service life.

### Third Detailed Representative Embodiment

The third detailed representative embodiment will now be described in detail with reference to FIGS. 8(A) to 8(D).

Because the third embodiment relates to the first embodiment, only the constructions and elements that are different from the first embodiment will be explained in detail. Elements that are the same in the first and third embodiments will be identified by the same reference numerals and a detailed description of such elements may be omitted.

As shown in FIG. 8(A), in this embodiment, the hole main portion 31 (the cord hole 30) of the first embodiment is replaced with a hole main portion 31B (the cord hole 30B). Further, the power-supply cord arrangement structure S1 of the first embodiment is replaced with a power-supply cord arrangement structure S3. Similar to the first embodiment, the guide rib member 41 of the power-supply cord arrangement structure S3 may constitute a portion of the hole main portion 31B (the cord hole 30B). Further, the guide rib member 41 includes a front guide rib 411B corresponding to the front guide rib 411 of the first embodiment. However, in this embodiment, the angled portion 411a in the first embodiment is omitted. That is, no angled portion is formed in the front guide rib 411B. Further, similar to the first embodiment, the front guide rib 411B has a front inner guide portion 431B corresponding to the front inner guide portion 431 of the first embodiment. However, as described above, no angled portion is formed in the front guide rib 411B. Therefore, no convex portion is not formed in the front inner guide portion 431B. That is, the front inner guide portion 431B does not have a convex portion corresponding to the convex portion 431a of the first embodiment.

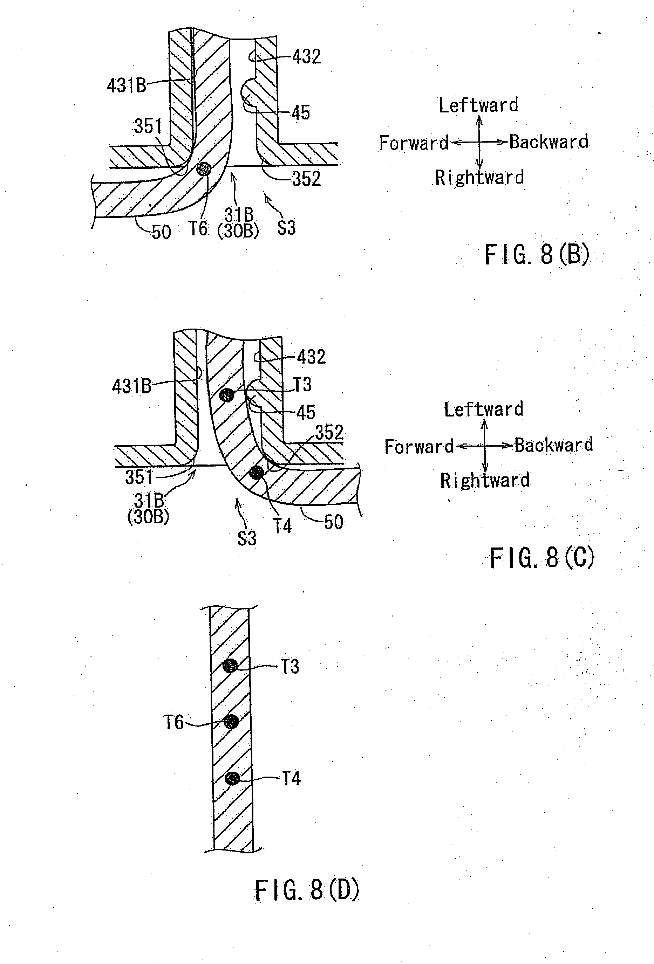

In this embodiment, as shown in FIG. 8(B), when the power-supply cord 50 is pulled forwardly, unlike the first embodiment, the tensile load of the power-supply cord 50 can be applied to the front support portion 351. As a result, the reaction force corresponding to the tensile load can be applied to the power-supply cord 50 via the front support portion 351. At this time, the reaction force can be applied to a (sixth) action point T6 on the power-supply cord 50.

Conversely, as shown in FIG. 8(C), when the power-supply cord 50 is pulled backwardly, similar to the first embodiment, the tensile load of the power-supply cord 50 can be applied to the projection 45 and the back support portion 352. As a result, the reaction force corresponding to the tensile load can be applied to the power-supply cord 50 via the projection 45 and the back support portion 352. The reaction force can be distributed to the action point T3 and the action point T4 on the power-supply cord 50. Further, in this embodiment, the projection 45 and the back support portion 352 are arranged and constructed such that the action point T6 cannot coincide with the action point T3 and the action point T4.

Thus, in this embodiment, when the power-supply cord 50 is pulled forwardly and backwardly, the power-supply cord 50 can contact the load support portions at a plurality of different contact points, so that the reaction force corresponding to the tensile load applied to the power-supply cord 50 can be received by a plurality of action points (i.e., the three action points T3, T4 and T6) that are different from each other (FIG. 8(D)). That is, the reaction force can be prevented from being concentrated in a single action point.

According to the power-supply cord arrangement structure S3, the power-supply cord 50 may have three different action points T3, T4 and T6 of the reaction force. Therefore, similar to the power-supply cord arrangement structure S1 of the first embodiment, the reaction force can be prevented from being concentrated in a single action point. As a result, the power-supply cord 50 can be avoided from being rapidly deteriorated or damaged. This means that the power-supply cord 50 can have a long service life.

### Fourth Detailed Representative Embodiment

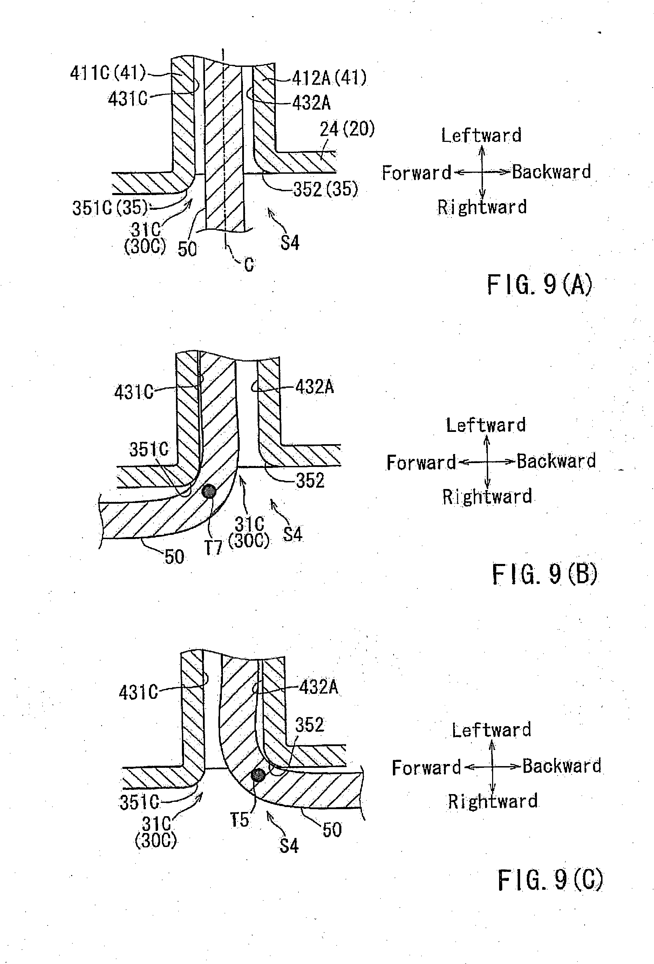

The fourth detailed representative embodiment will now be described in detail with reference to FIGS. 9(A) to 9(D).

Because the fourth embodiment relates to the second embodiment, only the constructions and elements that are different from the second embodiment will be explained in detail. Elements that are the same in the second and fourth embodiments will be identified by the same reference numerals and a detailed description of such elements may be omitted.

As shown in FIG. 9(A), in this embodiment, the hole main portion 31A (the cord hole 30A) of the second embodiment is replaced with a hole main portion 31C (the cord hole 30C). Further, the power-supply cord arrangement structure S2 of the second embodiment is replaced with a power-supply cord arrangement structure S4. Similar to the second embodiment, the guide rib member 41 of the power-supply cord arrangement structure S4 may constitute a portion of the hole main portion 31C (the cord hole 30C). Further, the guide rib member 41 includes a front guide rib 411C corresponding to the front guide rib 411 of the second embodiment. However, in this embodiment, the angled portion 411a in the second embodiment is omitted. That is, no angled portion is formed in the front guide rib 411C. Further, similar to the second embodiment, the front guide rib 411C has a front inner guide portion 431C corresponding to the front inner guide portion 431 of the second embodiment. However, as described above, because no angled portion is formed in the front guide rib 411C, no convex portion is not formed in the front inner guide portion 431C. That is, the front inner guide portion 431C does not have a convex portion corresponding to the convex portion 431a of the second embodiment.

Further, the end peripheral portion 35 includes a front support portion 351C corresponding to the front support portion 351 of the second embodiment. However, in this embodiment, the side wall 24 of the bottom cover 20 is unevenly shaped around the end peripheral portion 35 such that the front support portion 351C and the back support portion 352 can be unevenly positioned in the lateral direction. In particular, in this embodiment, the side wall 24 of the bottom cover 20 is shaped such that the front support portion 351C can be positioned outside of the back support portion 352 in the lateral direction.

In this embodiment, as shown in FIG. 9(B), when the power-supply cord 50 is pulled forwardly, unlike the second embodiment, the tensile load of the power-supply cord 50 can be applied to the front support portion 351C. As a result, the reaction force corresponding to the tensile load can be applied to the power-supply cord 50 via the front support portion 351C. At this time, the reaction force can be applied to a (seventh) action point T7 on the power-supply cord 50.

Conversely, as shown in FIG. 9(C), when the power-supply cord 50 is pulled backwardly, similar to the second embodiment, the power-supply cord 50 can be bent or flexed backwardly, so as to be pressed against the back support portion 352. At this time, the tensile load of the power-supply cord 50 can be applied to the back support portion 352. As a result, the reaction force corresponding to the tensile load can be applied to the power-supply cord 50 via the back support portion 352. The reaction force applied to the power-supply cord 50 can be applied to the (fifth) action point T5 on the power-supply cord 50, which point is not coincide with the action point T7.

Thus, in this embodiment, when the power-supply cord 50 is pulled forwardly and backwardly, the power-supply cord 50 can contact the load support portions at a plurality of different contact points, so that the reaction force corresponding to the tensile load applied to the power-supply cord 50 can be received by a plurality of action points (i.e., the three action points T5 and T7) that are different from each other (FIG. 9(D)). That is, the reaction force can be prevented from being concentrated in a single action point.

According to the power-supply cord arrangement structure S4, the power-supply cord 50 may have two different action points T5 and T7 of the reaction force. Therefore, similar to the power-supply cord arrangement structure S2 of the second embodiment, the reaction force can be prevented from being concentrated in a single action point. As a result, the power-supply cord 50 can be avoided from being rapidly deteriorated or damaged. This means that the power-supply cord 50 can have a long service life.

Various changes and modifications may be made to the first to fourth embodiments. For example, in the embodiments, the power-supply cord arrangement structure S1, S2, S3 and S4 is applied to the battery charger 10. However, the power-supply cord arrangement structure S1, S2, S3 and S4 can be applied to various electrical equipments other than the battery charger 10.

Further, the shapes and arrangement of the end peripheral portion 35 formed in the bottom cover 20 and the guide rib member 41 (the inner guide portion 43) can be changed as necessary. In other words, the number and positions of the action points T1 to T7 of the reaction force can be appropriately changed as necessary.

Representative examples of the present invention have been described in detail with reference to the attached drawings. This detailed description is merely intended to teach a person of skill in the art further details for practicing preferred aspects of the present invention and is not intended to limit the scope of the invention. Only the claims define the scope of the claimed invention. Therefore, combinations of features and steps disclosed in the foregoing detail description may not be necessary to practice the invention in the broadest sense, and are instead taught merely to particularly describe detailed representative examples of the invention. Moreover, the various features taught in this specification may be combined in ways that are not specifically enumerated in order to obtain additional useful embodiments of the present invention.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A power-supply cord arrangement structure (S1; S2; S3; S4) provided to an electrical equipment (10), comprising:
a cord drawing hole (30; 30A; 30B; 30C) that is formed in an outer wall (12) of a housing (11) of the electrical equipment (10) and is configured to have a power-supply cord (50) drawn therethrough, and
load support portions (351, 352, 431, 432; 351, 352, 431, 432A; 351, 352, 431B, 432; 351C, 352, 431C, 432A) that are formed in the housing (11) as a portion of the cord drawing hole (30; 30A; 30B; 30C) and are configured to support a tensile load of the power-supply cord (50) when the power-supply cord (50) is pulled,
wherein the load support portions are oppositely asymmetrically formed in cord pulling directions in a front-back direction of the outer wall (12), **characterized in that** the load support portions comprise outer support portions (351, 352; 351, 352; 351, 352; 351C, 352) that are oppositely asymmetrically formed in the cord pulling directions.

2. The power-supply cord arrangement structure as defined in claim 1, wherein the outer support portions (351, 352; 351, 352; 351, 352; 351C, 352) are respectively shaped to have radii of curvatures different from each other.

3. The power-supply cord arrangement structure as defined in claim 1 or 2, wherein the outer support portions (351C, 352) are respectively shaped to be unevenly positioned each other in the cord pulling directions.

4. The power-supply cord arrangement structure as defined in any of claims 1 to 3, wherein the load support portions comprise inner support portions (431, 432; 431, 432A; 431B, 432; 431C, 432A) that are oppositely asymmetrically formed in the cord pulling directions.

5. The power-supply cord arrangement structure as defined in claim 4, wherein the inner support portions (431, 432) respectively have a convex portion (431a) and a projection (45).

6. The power-supply cord arrangement structure as defined in claim 4, wherein one of the inner support portions (431, 432A) has a convex portion (431a).

7. The power-supply cord arrangement structure as defined in claim 4, wherein the one of the inner support portions (431B, 432) has a projection (45).

8. The power-supply cord arrangement structure as defined in any of claims 1 to 7, wherein the load support portions are shaped to contact the power-supply cord (50) at a plurality of different contact points when the power-supply cord (50) is pulled.

9. The power-supply cord arrangement structure as defined in any of claims 1 to 8 further comprising a cord retainer portion (21) having a cord guide wall member (25) that is formed in the housing (11), wherein the cord guide wall member (25) defines a winding guide path (P) so as to windingly guide and support the power-supply cord (50) along the guide path (P) while the power-supply cord (50) is bent a plurality of times.

10. The power-supply cord arrangement structure as defined in claim 9, wherein the cord guide wall member (25) is shaped such that an upper end surface (255) thereof can be positioned above upper end peripheries of vertically positioned surfaces (51) of the powder-supply cord (50) disposed along the guide path (P).

## Patentansprüche

1. Leistungszufuhrkabelanordnungsstruktur (S1; S2; S3; S4), die an einem elektrischen Gerät (10) vorgesehen ist, mit
einem Kabeleinziehloch (30; 30A; 30B; 30C), das in einer äußeren Wand (12) eines Gehäuses (11) des elektrischen Geräts (10) ausgebildet ist, und konfiguriert ist, ein dort hindurch gezogenes Leistungszufuhrkabel (50) aufzuweisen, und
Lastabfangteile (351, 352, 431, 432, 351, 352, 431, 432A; 351, 352, 431B, 432; 351C, 352, 431C, 432A), die in dem Gehäuse (11) als ein Teil des Kabeleinziehlochs (30; 30A; 30B; 30C) ausgebildet sind und konfiguriert sind, eine Zuglast des Leistungszufuhrkabels (50) abzufangen, wenn das Leistungszufuhrkabel (50) eingezogen ist,
bei der die Lastabfangteile gegenüberliegend asymmetrisch in den Kabeleinziehrichtungen in einer Vorder-Rück-Richtung der äußeren Wand (12) ausgebildet sind, **dadurch gekennzeichnet, dass** die Lastabfangteile äußere Abfangteile (351, 352; 351, 352; 351, 352; 351C, 352) aufweisen, die in der Kabeleinziehrichtung gegenüberliegend asymmetrisch ausgebildet sind.

2. Leistungszufuhrkabelanordnungsstruktur nach Anspruch 1, bei der die äußeren Abfangteile (351, 352; 351, 352; 351, 352; 351C, 352) jeweils so geformt sind, dass sie voneinander unterschiedliche Krümmungsradien aufweisen.

3. Leistungszufuhrkabelanordnungsstruktur nach Anspruch 1 oder 2, bei der die äußeren Abfangteile (351C, 352) jeweils so ausgeformt sind, dass sie in der Kabeleinziehrichtung ungleich einander positioniert sind.

4. Leistungszufuhrkabelanordnungsstruktur nach einem der Ansprüche 1 bis 3, bei der die Lastabfangteile innere Abfangteile (431, 432; 431, 432A; 431B, 432; 431C, 432A) aufweisen, die in der Kabeleinziehrichtung gegenüberliegend asymmetrisch ausgebildet sind.

5. Leistungszufuhrkabelanordnungsstruktur nach Anspruch 4, bei der die inneren Abfangteile (431, 432) jeweils einen konvexen Teil (431A) und einen Vorsprung (45) aufweisen.

6. Leistungszufuhrkabelanordnungsstruktur nach Anspruch 4, bei der einer von den inneren Abfangteilen (431, 432A) einen konvexen Teil (431a) aufweist.

7. Leistungszufuhrkabelanordnungsstruktur nach Anspruch 4, bei der einer der inneren Abfangteile (431B, 432) einen Vorsprung (45) aufweist.

8. Leistungszufuhrkabelanordnungsstruktur nach einem der Ansprüche 1 bis 7, bei der die Lastabfangsteile so ausgeformt sind, dass sie das Leistungszufuhrkabel (50) an einer Mehrzahl von unterschiedlichen Kontaktpunkten berühren, wenn das Leistungszufuhrkabel (50) eingezogen ist.

9. Leistungszufuhrkabelanordnungsstruktur nach einem der Ansprüche 1 bis 8, das weiter ein Kabelhalteteil (21) aufweist, das ein Kabelführungswandbauteil (25) aufweist, das in dem Gehäuse (11) ausgebildet ist, wobei das Kabelführungswandbauteil (25) einen Wicklungsführungspfad (P) definiert, um das Leistungszufuhrkabel (50) entlang des Führungspfades (P) gewunden zu führten, während das Leistungszufuhrkabel (50) mehrfach gebogen wird.

10. Leistungszufuhrkabelanordnungsstruktur nach Anspruch 9, bei der das Kabelführungswandbauteil (25) ausgeformt ist, so dass eine obere Endoberfläche (255) davon oberhalb oberen Endumfängen von vertikal positionierten Oberflächen (51) des Leistungszufuhrkabels (50), das entlang des Führungspfades (P) angeordnet ist, positioniert werden kann.

## Revendications

1. Structure d'agencement de câble d'alimentation électrique (S1 ; S2 ; S3 ; S4) prévu pour un équipement électrique (10), comprenant :
un trou de tirage de câble (30 ; 30A ; 30B ; 30C) qui est formé dans une paroi extérieure (12) d'un boîtier (11) de l'équipement électrique (10) et est configuré pour avoir un câble d'alimentation électrique (50) tiré à travers celui-ci, et
des portions de support de charge (351, 352, 431, 432 ; 351, 352, 431, 432A ; 351, 352, 431 B, 432 ; 351 C, 352, 431 C, 432A) qui sont formées dans le boîtier (11) comme une portion du trou de tirage de câble (30 ; 30A ; 30B ; 30C) et sont configurées pour supporter une charge de traction du câble d'alimentation électrique (50) quand le câble d'alimentation électrique (50) est tiré,
dans laquelle les portions de support de charge sont formées de manière opposée et asymétrique dans des directions de traction du câble dans une direction avant-arrière de la paroi extérieure (12), **caractérisée en ce que** les portions de support de charge comprennent des portions de support extérieures (351, 352 ; 351, 352 ; 351, 352; 351C, 352) qui sont formées de manière opposée et asymétrique dans des directions de traction du câble.

2. Structure d'agencement de câble d'alimentation électrique selon la revendication 1, dans laquelle les portions de support extérieures (351, 352 ; 351, 352 ; 351, 352 ; 351C, 352) sont respectivement profilées pour avoir des rayons de courbure différents les uns des autres.

3. Structure d'agencement de câble d'alimentation électrique selon la revendication 1 ou 2, dans laquelle les portions de support extérieures (351 C, 352) sont respectivement profilées pour être positionnées irrégulièrement les unes par rapport aux autres dans les directions de traction du câble.

4. Structure d'agencement de câble d'alimentation électrique selon l'une quelconque des revendications 1 à 3, dans laquelle les portions de support de charge comprennent des portions de support intérieures (431, 432; 431, 432A ; 431 B, 432; 431 C, 432A) qui sont formées de manière opposée et asymétrique dans des directions de traction du câble.

5. Structure d'agencement de câble d'alimentation électrique selon la revendication 4, dans laquelle les portions de support intérieures (431, 432) ont respectivement une portion convexe (431 a) et une saillie (45).

6. Structure d'agencement de câble d'alimentation électrique selon la revendication 4, dans laquelle une des portions de support intérieures (431, 432A) a une portion convexe (431 a).

7. Structure d'agencement de câble d'alimentation électrique selon la revendication 4, dans laquelle l'une des portions de support intérieures (431 B, 432) a une saillie (45).

8. Structure d'agencement de câble d'alimentation électrique selon l'une quelconque des revendications 1 à 7, dans laquelle les portions de support de charge sont profilées pour être en contact avec le câble d'alimentation électrique (50) en une pluralité de points de contact différents quand le câble d'alimentation électrique (50) est tiré.

9. Structure d'agencement de câble d'alimentation électrique selon l'une quelconque des revendications 1 à 8, comprenant en outre une portion de retenue de câble (21) ayant un élément de paroi de guidage de câble (25) qui est formé dans le boîtier (11), dans laquelle l'élément de paroi de guidage de câble (25) définit une voie de guidage d'enroulement (P) de manière à guider sinueusement et supporter le câble d'alimentation électrique (50) le long de la voie de guidage (P) alors que le câble d'alimentation électrique (50) est plié une pluralité de fois.

10. Structure d'agencement de câble d'alimentation électrique selon la revendication 9, dans laquelle l'élément de paroi de guidage de câble (25) est profilé de manière qu'une surface d'extrémité supérieure (255) de celui-ci puisse être positionnée au-dessus de périphéries terminales supérieures de surfaces positionnées verticalement (51) du câble d'alimentation électrique (50) disposé le long de la voie de guidage (P).
